# EUROPÄISCHE PATENTSCHRIFT

(11) **EP 1 223 669 B1**
(45) Veröffentlichungstag und Bekanntmachung des Hinweises auf die Patenterteilung: **04.10.2006**
(21) Anmeldenummer: 01121703.1
(22) Anmeldetag: 17.09.2001
(51) Int. Cl.: H03C 1/36, H04L 27/04, H01P 1/15

(54) **Amplitudenmodulator und Verfahren dazu**
Amplitude modulator and process
Modulateur d'amplitude et procédé

(30) Priorität: 30.11.2000 DE 10059585
(43) Veröffentlichungstag der Anmeldung: 17.07.2002
(73) Patentinhaber: Valeo Schalter und Sensoren GmbH, 74321 Bietigheim-Bissingen (DE)
(72) Erfinder: Künzler, Frank, 76703 Kraichtal-Menzingen (DE)
(74) Vertreter: Dreiss, Fuhlendorf, Steimle & Becker

(56) Entgegenhaltungen:
- FR-A- 2 133 527
- US-A- 4 107 630
- US-A- 5 697 076
- PATENT ABSTRACTS OF JAPAN vol. 016, no. 469 (E-1271), 29. September 1992 (1992-09-29) -& JP 04 167645 A (MATSUSHITA ELECTRIC WORKS LTD), 15. Juni 1992 (1992-06-15)
- ALEKSEEV E ET AL: "InGaAs PIN diodes for high-isolation W-band monolithic integrated switching applications" HIGH SPEED SEMICONDUCTOR DEVICES AND CIRCUITS, 1997. PROCEEDIINGS., 1997 IEEE/CORNELL CONFERENCE ON ADVANCED CONCEPTS IN ITHACA, NY, USA 4-6 AUG. 1997, NEW YORK, NY, USA,IEEE, US, 4. August 1997 (1997-08-04), Seiten 332-340, XP010264385 ISBN: 0-7803-3970-3
- KOBAYASHI K W ET AL: "MONOLITHIC GAAS HBT P-I-N DIODE VARIABLE GAIN AMPLIFIERS, ATTENUATORS, AND SWITCHES" IEEE TRANSACTIONS ON MICROWAVE THEORY AND TECHNIQUES, IEEE INC. NEW YORK, US, Bd. 41, Nr. 12, 1. Dezember 1993 (1993-12-01), Seiten 2295-2302, XP000426147 ISSN: 0018-9480
- MANSOUR R R ET AL: "Analysis of microstrip T-junction and its application to the design of transfer switches" MICROWAVE SYMPOSIUM DIGEST, 1992., IEEE MTT-S INTERNATIONAL ALBUQUERQUE, NM, USA 1-5 JUNE 1992, NEW YORK, NY, USA,IEEE, US, 1. Juni 1992 (1992-06-01), Seiten 889-892, XP010063048 ISBN: 0-7803-0611-2

## Beschreibung

Die vorliegende Erfindung betrifft eine elektrische Schaltung zur Pulsmodulation eines Trägersignals. Die Schaltung umfasst einen Pulsgenerator zur Erzeugung eines Stromimpulses und mindestens einen von dem Stromimpuls ansteuerbaren Diodenschalter mit einer Diode. Der Diodenschalter weist eine Signalleitung und eine von dieser abzweigende Lambda/4-Stichleitung auf. Das Trägersignal liegt an einem Eingang der Signalleitung und das pulsmodulierte Trägersignal an einem Ausgang der Signalleitung an. Die Signalleitung ist während des Stromimpulses durchgeschaltet.

Die Erfindung betrifft außerdem ein Verfahren zur Pulsmodulation eines Trägersignals umfassend die Schritte:
- Erzeugen eines Stromimpulses;
- Ansteuern mindestens eines Diodenschalters mit dem Stromimpuls, wobei der mindestens eine Diodenschalter eine Signalleitung und eine von dieser abzweigende Lambda/4-Stichleitung aufweist;
- Anlegen des Trägersignals an einem Eingang der Signalleitung;
- Abgreifen des pulsmodulierten Trägersignals an einem Ausgang der Signalleitung; und
- Durchschalten der Signalleitung während des Stromimpulses.

Schaltungen der eingangs genannten Art werden bspw. zur Pulsmodulation eines hochfrequenten Trägersignals verwendet, die bspw. bei Abstandsradar-Systemen aus dem Kraftfahrzeugbereich zum Einsatz kommen. Dabei schaltet der Diodenschalter ausgelöst durch den von dem Pulsgenerator erzeugten Stromimpuls ein Hochfrequenz (HF)-Signal für eine sehr kurze Zeitdauer (0,1 bis 10 ns) durch.

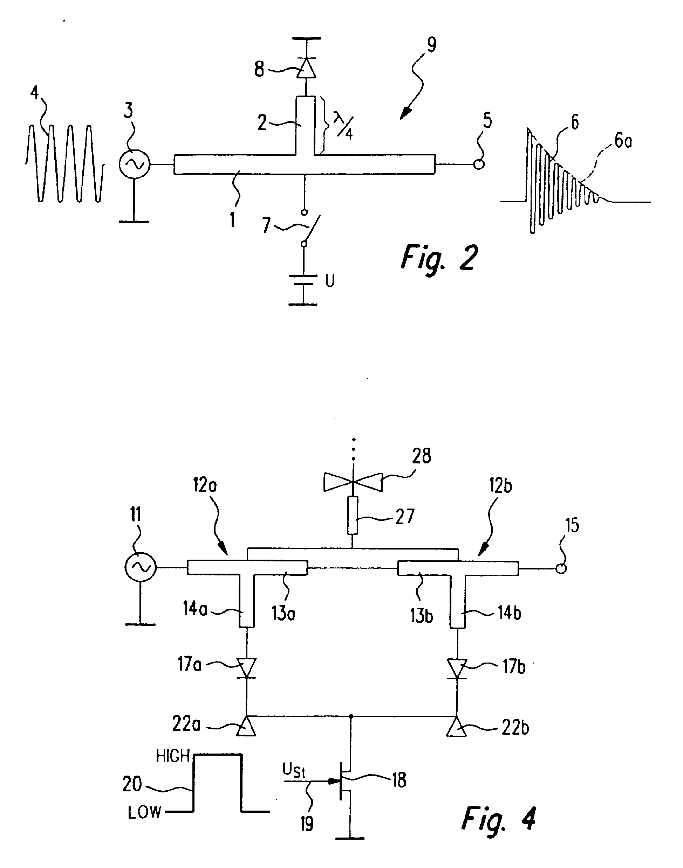

Zunächst wird die Funktionsweise eines Diodenschalters anhand einer in Figur 2 dargestellten, aus dem Stand der Technik bekannten elektrischen Schaltung näher erläutert. Ein typischer Diodenschalter 9 umfasst eine Signalleitung 1 und eine davon abzweigende Lambda/4-Stichleitung 2. Am Eingang der Signalleitung 2 ist ein Oszillator 3 angeordnet, der ein hochfrequentes Trägersignal 4 liefert. An der Stichleitung 2 ist eine Steuerspannungsquelle U angeschlossen, wobei die Steuerspannung U durch Schließen eines Schalters 7 an die Stichleitung 2 angelegt und durch Öffnen des Schalters 7 von der Stichleitung 2 wieder getrennt werden kann. Durch kontinuierliches Öffnen und Schließen des Schalters 7 wird das Trägersignal 4 pulsmoduliert und an einem Ausgang 5 der Signalleitung 1 liegt das pulsmodulierte hochfrequente Trägersignal 6 an.

Wenn eine am Ende der Stichleitung 2 angeordnete Diode 8 leitet (Schalter 7 geschlossen), kann ein Signal von dem Oszillator 3 zum Ausgang 5 des Diodenschalters 9 gelangen. Wenn die Diode 8 sperrt (Schalter 7 offen), kann kein Signal vom Oszillator 3 zum Ausgang 5 gelangen. Durch die an der Diode 8 angeschlossene Lambda/4-Stichleitung 2 wird das Verhalten der Diode 8 "invertiert". Bei Leerlauf (Diode 8 sperrend) und bei Kurzschluss (Diode 8 leitend) wird das Signal in der Stichleitung 2 reflektiert. Dadurch kommt es bei einem Leerlauf zu einer destruktiven Überlagerung (einfallendes und reflektiertes Signal sind um eine halbe Periodendauer relativ zueinander phasenverschoben) nach der Lambda/4-Stichleitung 2. Im Falle eines Kurzschlusses überlagern sich die Signale konstruktiv (einfallendes und reflektiertes Signal sind relativ zueinander nicht phasenverschoben) nach der Lambda/4-Stichleitung 2.

Als Diode 8 wird meist eine PIN-Diode eingesetzt. Mit einer PIN-Diode können Schaltzeiten (kürzester erzeugbarer Puls am Ausgang 5) von größer 10 ns erreicht werden. Von Vorteil ist der sehr geringe Widerstand der PIN-Diode im durchgeschalteten Zustand. Um wesentlich schnellere Schaltzeiten zu erreichen, kann anstelle der PIN-Diode eine Schottky-Diode eingesetzt werden. Sie erlaubt Schaltzeiten im Sub-ns-Bereich.

Störend wirkt sich allerdings der wesentlich höhere dynamische Widerstand der Schottky-Diode aus. Der dynamische Widerstand der Diode bestimmt die Einfügedämpfung des Diodenschalters (also die Verluste). Die parasitären Größen, insbesondere die Kapazität, bestimmten die maximal erreichbare Isolation des Diodenschalters 9. Der minimal erreichbare Leistungsverlust des Diodenschalters 9, d.h. bei leitender Diode 8, wird durch den dynamischen Widerstand der Diode 8 vorgegeben. Die Kapazität lässt einen geringen Strom auch bei sperrendem Zustand der Diode 8 gegen Masse abfließen. Die Isolation des Diodenschalters 9 kann durch eine zweite, parallel zu der ersten Diode 8 geschaltete Diode verdoppelt werden. Dabei verdoppelt sich allerdings auch der minimal erreichbare Leistungsverlust bei durchgeschaltetem Diodenschalter 9.

Ein weiterer Nachteil der in Figur 2 dargestellten Schaltung besteht darin, dass die Einhüllende 6a des am Ausgang 5 des Diodenschalters 9 anliegenden pulsmodulierten hochfrequenten Trägersignals 6 keinen sauberen Rechteck-Verlauf aufweist. Der Verlauf der Einhüllenden entspricht vielmehr einer e-Funktion (e^{-t}). Beim Einsatz der bekannten Schaltung bspw. in einem Abstandsradar-System kann eine umso höhere Ortsauflösung erzielt werden, je kürzer die ausgesandten Impulse sind. Allerdings sinkt mit kürzeren Impulsen auch die Energie des Signals, wodurch das Signal besonders störanfällig wird. Aus diesem Grund ist es insbesondere bei sehr kurzen Impulsen wichtig, dass das ausgesandte Signal, also das am Ausgang 5 des Diodenschalters 9 anliegende pulsmodulierte Signal 6, eine saubere Einhüllende 6a, vorzugsweise einen Rechteck-Verlauf, aufweist.

Aus der JP 4-167645, veröffentlicht am 15.06.1992, ist eine elektrische Schaltung der eingangs genannten Art bekannt. Bei der bekannten Schaltung wird jedoch ein an der Stichleitung angeschlossener Halbleiterschalter bewusst mit einem abgerundeten Modulationsimpuls angesteuert, um die Ordnung unerwünschter Harmonischer zu reduzieren. Die Einhüllende des pulsmodulierten Trägersignals weist keinen sauberen Rechteck-Verlauf auf, wodurch diese Schaltung für den Einsatz bspw. in einem Abstandsradar-System ungeeignet ist.

Aus der FR 2 133 527 ist ebenfalls eine elektrische Schaltung der eingangs genannten Art bekannt. Allerdings dient diese Schaltung lediglich zur Pulsmodulation niederfrequenter Signale. Kondensatoren, die in der Schaltung vorgesehen sind, sind Teil eines Tiefpassfilters, das dazu dient, hochfrequente Anteile in dem zu modulierenden Signal zu eliminieren. Auch diese Schaltung ist für den Einsatz bspw. in einem Abstandsradar-System ungeeignet.

Aus dem Vorgesagten ergibt sich die Aufgabe der vorliegenden Erfindung, eine Schaltung und ein Verfahren zu schaffen, um einem Trägersignal möglichst kurze Pulse mit einer sauberen rechteckförmigen Einhüllenden aufzumodulieren.

Zur Lösung dieser Aufgabe schlägt die Erfindung ausgehend von der elektrischen Schaltung der eingangs genannten Art vor, dass die Schaltung mindestens ein aufladbares kapazitives Element aufweist und der Stromimpuls durch Entladen des kapazitiven Elements über die Stichleitung erzeugt wird.

Das kapazitive Element ist bspw. als ein Kondensator ausgebildet. Es kann ein einzelner Kondensator oder aber eine Serienschaltung, eine Parallelschaltung oder eine Kombination aus Serien- und Parallelschaltung mehrerer Kondensatoren eingesetzt werden. Mit der erfindungsgemäßen elektrischen Schaltung können einem Trägersignal sehr kurze Pulse mit einer besonders sauberen rechteckförmigen Einhüllenden aufmoduliert werden. Zudem kann die erfindungsgemäße Schaltung besonders preiswert realisiert werden.

Das mindestens eine kapazitive Element wird zunächst über einen Ladewiderstand aufgeladen. Anschließend kann das mindestens eine kapazitive Element zu einem gewünschten Zeitpunkt entladen werden. Der Entladestrom dient dabei zur Ansteuerung des mindestens einen Diodenschalters der elektrischen Schaltung. Durch schnelles Entladen des kapazitiven Elements können sehr kurze Strom-Impulse erzeugt werden. Ein Entladestrom fließt dabei nur solange bis das mindestens eine kapazitive Element entladen ist. Der Ladewiderstand ist so zu dimensionieren, dass sich das oder jedes kapazitive Element nach dem Entladen bis zu dem nächsten Strom-Impuls wieder nahezu vollständig aufladen kann.

Gemäß einer vorteilhaften Weiterbildung der vorliegenden Erfindung wird vorgeschlagen, dass die Schaltung mehrere Diodenschalter mit parallel zueinander geschalteten Stichleitungen aufweist. In den Zweigen der Stichleitungen ist jeweils eine Diode angeordnet, durch die sichergestellt wird, dass der Entladestrom nur in eine Richtung fließt. Durch die Parallelschaltung mehrerer Dioden kann die maximal erzielbare Isolation des Diodenschalters deutlich erhöht werden.

Gemäß einer anderen vorteilhaften Weiterbildung der vorliegenden Erfindung wird vorgeschlagen, dass die Schaltung mindestens einen mit dem oder jedem Diodenschalter in Serie geschalteten Halbleiterschalter aufweist, wobei das aufgeladene kapazitive Element nach Ansteuerung des bzw. mindestens eines Halbleiterschalters durch einen Ansteuerimpuls über den oder jeden Halbleiterschalter und den oder jeden Diodenschalter entladbar ist. Das mindestens eine kapazitive Element wird also durch Ansteuerung eines Halbleiterschalters mit einem Ansteuerimpuls entladen. Der Ansteuerimpuls dient lediglich zum Anstoßen des Entladevorgangs. Er kann auch länger als der Strom-Impuls dauern. Sobald das kapazitive Element entladen ist, ist auch der Strom-Impuls beendet, unabhängig davon, ob der Ansteuerimpuls an dem Halbleiterschalter noch anliegt oder nicht.

Der oder jeder Halbleiterschalter ist vorteilhafterweise als ein Transistor ausgebildet. Vorzugsweise ist der oder jeder Halbleiterschalter als ein Feldeffekt-Transistor (FET) ausgebildet. Ein FET hat nahezu ohmsches Verhalten im durchgeschalteten Zustand.

Gemäß einer bevorzugten Ausführungsform der vorliegenden Erfindung wird vorgeschlagen, dass die Schaltung zwei Halbleiterschalter aufweist, wobei an einem Steuerkontakt des einen Halbleiterschalters der Ansteuerimpuls anlegbar ist und an einem Steuerkontakt des anderen Halbleiterschalters eine variierbare Gleichspannung anliegt. Durch Anlegen des Ansteuerimpulses an den einen Halbleiterschalter wird der Entladevorgang des kapazitiven Elements eingeleitet. Mittels der an dem anderen Halbleiterschalter anliegenden variierbaren Gleichspannung kann der minimale Widerstand im leitenden Zustand des anderen Halbleiterschalters eingestellt werden. Je größer der Widerstand des Halbleiterschalters im leitenden Zustand ist, desto länger dauert es, bis das mindestens eine kapazitive Element vollständig entladen ist, desto länger ist der erzeugte Strom-Impuls und desto länger sind die Pulse, die dem Trägersignal von der erfindungsgemäßen Schaltung aufmoduliert werden.

Über die variierbare Gleichspannung kann bspw. bei Abstandsradar-Systemen die Ortsauflösung bzw. die Signalenergie der ausgesandten Impulse eingestellt werden. Um in der Ferne liegende Bereiche abzutasten, können längere Impulse mit einer höheren Energie ausgesandt werden. Um in der Nähe liegende Bereiche abzutasten, können kürzere Impulse ausgesandt werden. Die kurzen Impulse weisen eine höhere Ortsauflösung auf, so dass auch kleine Hindernisse sicher und zuverlässig detektiert werden können.

Die zwei Halbleiterschalter sind vorteilhafterweise als ein Feldeffekt-Transistor (FET) mit zwei Gates ausgebildet. Derartige FETs werden auch als Dual-Gate-FETs bezeichnet. Über die variierbare Gleichspannung kann der maximale Drainstrom des Dual-Gate-FET und damit die Entladezeit des kapazitiven Elements bzw. die Pulsdauer des pulsmodulierten Trägersignals variiert werden. Der Drainstrom muss jedoch mindestens so groß sein, dass sämtliche Dioden des Diodenschalters durchgesteuert werden können.

Gemäß einer anderen vorteilhaften Weiterbildung der vorliegenden Erfindung wird vorgeschlagen, dass in einem Zweig der Schaltung, über den das kapazitive Element aufgeladen wird, ein während des Ladevorgangs in Durchlassrichtung geschaltetes Halbleiterbauelement angeordnet ist. Das Halbleiterbauelement ist vorteilhafterweise als eine Diode ausgebildet. Über ein derart geschaltetes Halbleiterbauelement kann das mindestens eine kapazitive Element während des Ladevorgangs ganz normal aufgeladen werden. Während des Entladevorgangs sperrt das Halbleiterbauelement jedoch und bewirkt, dass der gesamte Entladestrom über den Diodenschalter fließt und nicht über den Ladewiderstand abfließen kann.

Gemäß noch einer anderen vorteilhaften Weiterbildung der vorliegenden Erfindung wird vorgeschlagen, dass die Schaltung Mittel aufweist, die den Ladevorgang des mindestens einen kapazitiven Elements zumindest so lange unterbrechen, wie an dem bzw. an mindestens einem Halbleiterschalter der Ansteuerimpuls anliegt. Das Ladesignal für das mindestens eine kapazitive Element und das Ansteuersignal für den Halbleiterschalter liegen also niemals gleichzeitig auf HIGH.

Mit dieser Weiterbildung kann ein nach dem Entladevorgang über den Ladewiderstand fließender Reststrom vermieden werden. Durch das in dem Zweig der Schaltung, über den das mindestens eine kapazitive Element geladen wird, angeordnete Halbleiterbauelement kann ein Entladen des mindestens einen kapazitiven Elements über den Ladewiderstand verhindert werden, wenn das Ladesignal auf LOW liegt.

Gemäß einer bevorzugten Ausführungsform der vorliegenden Erfindung wird vorgeschlagen, dass die Mittel einseitig verzögernde Glieder zur Verzögerung der ansteigenden Flanken des Ansteuersignals und der ansteigenden Flanken des Ladesignals aufweisen. Das Ladesignal ist überlicherweise auf HIGH. Das Ansteuersignal ist außer während der Ansteuerimpulse üblicherweise auf LOW. Während der Ansteuerimpulse ist das Ansteuersignal auf HIGH. In einem ersten Schritt wird das invertierte Ansteuersignal als das Ladesignal herangezogen. Um schrägen Signalflanken Rechnung zu tragen und damit das Ladesignal während des Ansteuerimpulses sicher auf LOW ist, werden die verzögernden Glieder eingesetzt. Ein erstes Verzögerungsglied verzögert die ansteigende Flanke des Ansteuersignals, wobei das Ladesignal nach wie vor mit der ansteigenden Flanke des unverzögerten Ansteuersignals von HIGH auf LOW wechselt. Ein zweites Verzögerungsglied verzögert die ansteigende Flanke Ladesignals, so dass dieses zeitlich versetzt zu der abfallenden Flanke des Ansteuersignals von LOW auf HIGH wechselt. Bei dieser Ausführungsform liegt das Ladesignal sicher auf LOW, solange das Ansteuersignal auf HIGH ist.

Gemäß einer weiteren bevorzugten Ausführungsform der Erfindung kann eine Erhöhung der Isolation des Diodenschalters dadurch erzielt werden, dass in Serie mit der oder jeder Stichleitung des mindestens einen Diodenschalters mindestens ein während des Entladevorgangs in Durchlassrichtung geschaltetes Halbleiterbauelement angeordnet ist. Das Halbleiterbauelement ist vorteilhafterweise als eine Diode ausgebildet.

Gemäß einer anderen vorteilhaften Weiterbildung der vorliegenden Erfindung wird vorgeschlagen, dass die Schaltung einen parallel zu dem mindestens einen Zweig mit dem oder jedem Diodenschalter geschalteten invertierenden Zweig aufweist. Der Ausgang des mindestens einen Diodenschalters ist mit einem Widerstand abgeschlossen, der gleich dem Systemwiderstand ist. Dadurch wird eine Reflexion des an dem Ausgang anliegenden Signals verhindert. Wenn der mindestens eine Diodenschalter durchgeschaltet ist, wird die anliegende Leistung am Ausgang abgegriffen. Bei geöffnetem Diodenschalter wird am Ausgang keine Leistung abgegriffen. Stattdessen kann die Leistung bei dieser Weiterbildung an dem invertierenden Zweig abgegiffen werden. Die an dem invertierenden Zweig abgegriffene Leistung wird nicht genutzt. Das Abgreifen der Leistung führt jedoch dazu, dass die ungenutzte Leistung nicht am Ausgang des mindestens einen Diodenschalters reflektiert wird und sich nicht negativ auf den Oszillator zur Erzeugung des Trägersignals auswirkt. Die nicht abgegriffene reflektierte Leistung könnte nämlich zu einer Schwankung der Frequenz des Oszillators führen. Bei einem Einsatz der Schaltung bei Abstandsradar-Systemen könnte dadurch die Ortungsgenauigkeit und Ortungszuverlässigkeit beeinträchtigt werden. Durch das Abgreifen der ungenutzten Leistung kann also eine Entstörung des mindestens einen Diodenschalters erzielt werden.

Der invertierende Zweig weist vorteilhafterweise eine gegenüber den Zweigen mit dem mindestens einen Diodenschalter um Lambda/4 größere Länge auf. Wenn ein Diodenschalter mit einer Lambda/4-Stichleitung eingesetzt wird, ist der invertierende Zweig als eine etwa Lambda/2-Leitung ausgebildet. Damit die beiden Zweige sinnvoll zusammenarbeiten, d.h. der Oszillator am Eingang immer den Systemwiderstand sieht, müssen die beiden Zweige aneinander angepasst werden. Dazu werden die beiden Zweige zunächst getrennt voneinander betrieben. Beide Zweige werden so ausgelegt, dass sie bei durchgeschaltetem Zustand einen möglichst geringen Reflexionsfaktor besitzen.

Gemäß noch einer anderen vorteilhaften Weiterbildung der vorliegenden Erfindung wird vorgeschlagen, dass in einem Zweig der Schaltung, über den das kapazitive Element entladen wird, eine Reihenschaltung eines invertierenden Bauelements und eines wellenlängenselektiv reflektierenden Bauelements (sog. Stub) angeordnet ist, wobei das invertierende Bauelement zwischen dem wellenlängenselektiv reflektierenden Bauelement und dem oder jedem Diodenschalter angeordnet ist und das wellenlängenselektiv reflektierende Bauelement für einen Frequenzbereich, der die Frequenz des Trägersignals umfasst, reflektierend und für alle anderen Frequenzen leitend ist. Das invertierende Bauelement ist bspw. als eine Lambda/4-Leitung ausgebildet. Das invertierende Bauelement und das wellenlängenselektiv reflektierende Bauelement bewirken zusammen einen Kurzschluss für einen bestimmten HF-Frequenzbereich. Der Frequenzbereich umfasst die Frequenz des Trägersignals und andere Frequenzen im Bereich von 5.10⁻¹ bis 2 mal der Frequenz des Trägersignals.

Als eine weitere Lösung der Aufgabe der vorliegenden Erfindung wird ausgehend von dem Verfahren zur Pulsmodulation eines Trägersignals der eingangs genannten Art vorgeschlagen, dass der Stromimpuls durch Entladen eines aufladbaren kapazitiven Elements über die Stichleitung erzeugt wird.

Weitere Merkmale, Anwendungsmöglichkeiten und Vorteile der Erfindung ergeben sich aus der nachfolgenden Beschreibung von Ausführungsbeispielen der Erfindung, die in der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung. Es zeigen:
- Figur 1: eine erfindungsgemäße Schaltung gemäß einer ersten bevorzugten Ausführungsform;
- Figur 2: eine aus dem Stand der Technik bekannte Schaltung zur Pulsmodulation eines Trägersignals;
- Figur 3: einen Ausschnitt einer erfindungsgemäßen Schaltung gemäß einer zweiten bevorzugten Ausführungsform;
- Figur 4: einen Ausschnitt einer erfindungsgemäßen Schaltung gemäß einer dritten bevorzugten Ausführungsform;
- Figur 5: eine erfindungsgemäße Schaltung gemäß einer vierten bevorzugten Ausführungsform;
- Figur 6: einen Ausschnitt einer erfindungsgemäßen Schaltung gemäß einer fünften bevorzugten Ausführungsform; und
- Figur 7: einen Ausschnitt einer erfindungsgemäßen Schaltung gemäß einer sechsten bevorzugten Ausführungsform.

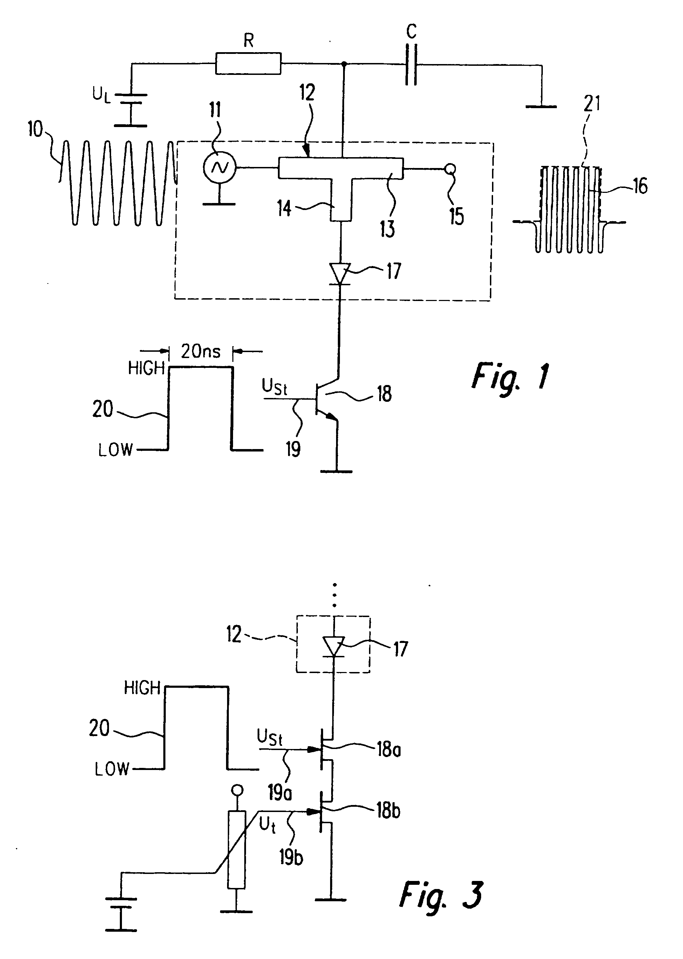

In Figur 1 ist eine erfindungsgemäße elektrische Schaltung zur Pulsmodulation eines hochfrequenten Trägersignals 10 gemäß einer ersten bevorzugten Ausführungsform dargestellt. Das pulsmodulierte hochfrequente Trägersignal 16 kann bspw. in einem Abstandsradar-System im Kraftfahrzeugbereich zur Ortung eines Objekts und zum Bestimmen des Abstands zwischen dem Kraftfahrzeug und dem Objekt eingesetzt werden.

Das hochfrequente Trägersignal 10 wird von einem Oszillator 11 erzeugt. Das Trägersignal 10 liegt an einem Eingang eines Diodenschalters 12 an. Der Diodenschalter 12 umfasst eine Signalleitung 13 und eine Lambda/4-Stichleitung 14, die von der Signalleitung 13 in etwa rechtwinklig abzweigt. An einem Ausgang 15 des Diodenschalters 12 liegt das pulsmodulierte hochfrequente Trägersignal 16 an.

Die erfindungsgemäße Schaltung umfasst des weiteren eine Spannungsquelle, die eine Ladespannung U_{L} für ein als Kondensator C ausgebildetes kapazitives Element liefert. Die Ladespannung U_{L} beträgt bspw. 5V. Während eines Ladevorgangs wird der Kondensator C über einen Ladewiderstand R aufgeladen. Die Werte für den Ladewiderstand R und den Kondensator C können stark variieren und hängen ab von: gewünschter Pulslänge, Betriebs- bzw. Ladespannung, eingesetztem Transistor 18 und Dioden 17 des Diodenschalters 12. In dem vorliegenden Ausführungsbeispiel hat der Ladewiderstand R einen Widerstandswert von 2 kOhm und der Kondensator C eine Kapazität von 30 pF.

An die Stichleitung 14 des Diodenschalters 12 ist eine Serienschaltung einer Diode 17 und eines als BipolarTransistor 18 ausgebildeten Halbleiterschalters angeschlossen. Durch den Transistor 18 wird der Entladevorgang des Kondensators C eingeleitet. An einem Steuerkontakt 19 (Basis) des Transistors 18 liegt eine Steuerspannung U_{St} an. Die Steuerspannung U_{St} umfasst zeitlich aufeinanderfolgende Ansteuerimpulse 20 mit einer bestimmten Pulslänge von bspw. 20 ns.

Wenn an dem Steuerkontakt 19 des Transistors 18 ein LOW-Signal anliegt, sperrt der Transistor 18, der Kondensator C kann nicht entladen werden. Wenn an dem Steuerkontakt 19 ein HIGH-Signal anliegt, schaltet der Transistor 18 durch und der Kondensator C wird über die Stichleitung 14 des Diodenschalters 12, die Diode 17 und den Transistor 18 entladen. Durch ein rasches Entladen des Kondensators C entsteht ein sehr kurzer Strom-Impuls. Die Länge des Strom-Impulses ist dabei unabhängig von der Länge des Ansteuerimpulses 20 an dem Steuerkontakt 19 des Transistors 18, sondern hängt vielmehr von dem minimalen Widerstand im leitenden Zustand des Transistors 18 ab.

Der Entladestrom des Kondensators C steuert den Diodenschalter 12 an und schaltet die Signalleitung 13 durch, so dass das hochfrequente Trägersignal 10 des Oszillators 11 für die Dauer des Strom-Impulses an dem Ausgang 15 des Diodenschalters 12 anliegt. Mittels des Entladestroms eines Kondensators C kann ein Strom-Impuls mit steil ansteigenden bzw. steil abfallenden Flanke und dadurch auch ein pulsmoduliertes Trägersignal 16 mit einer besonders sauberen rechteckförmigen Einhüllenden 21 erzeugt werden. Zudem lassen sich mittels des Entladestroms eines Kondensators C besonders kurze Strom-Impulse erzeugen, wobei die Impulslängen im Bereich von 0,1 ns bis 10 ns liegen können. Der Ladewiderstand R ist so zu dimensionieren, dass sich der Kondensator C von dem entladenen Zustand bis zu dem nächsten Strom-Impuls wieder nahezu vollständig aufladen kann.

In Figur 3 ist ein Ausschnitt einer erfindungsgemäßen Schaltung gemäß einer zweiten bevorzugten Ausführungsform dargestellt. Dabei wurde der Transistor 18 aus Figur 1 durch eine Serienschaltung zweier Feldeffekt-Transistoren (FET) 18a, 18b ersetzt. An einem Steuerkontakt 19a (Gate) des ersten FET 18a liegt die Steuerspannung U_{St} mit den Ansteuerimpulsen 20 an. An einem Steuerkontakt 19b (Gate) des zweiten FET 18b liegt dagegen eine variierbare Gleichspannung Uₜ an. Statt - wie in Figur 3 dargestellt - zwei getrennten FETs 18a, 18b kann auch ein FET mit zwei Steuerkanälen (Gates), ein sog. Dual-Gate-FET, eingesetzt werden.

Mittels der Gleichspannung Uₜ kann die Pulsbreite des pulsmodulierten Signals 16 variiert werden. Durch eine negative Gleichspannung Uₜ an dem Steuerkanal 19b wird der minimale Drain-Source-Widerstand vorgegeben, der bei einem positiven Ansteuerimpuls 20 an dem Steuerkanal 19a erreicht werden kann. Durch einen höheren Drain-Source-Widerstand wird die Entladezeit des Kondensators C und damit auch die Pulslänge des pulsmodulierten Trägersignals 16 verlängert. Solange ein Mindeststrom durch die Diode 17 aufrecht erhalten bleibt, ist die Diode 17 niederohmig.

In Figur 4 ist ein Ausschnitt einer erfindungsgemäßen Schaltung gemäß einer dritten bevorzugten Ausführungsform dargestellt. Dabei ist der Diodenschalter 12 mit der Diode 17 aus Figur 1 durch eine Parallelschaltung zweier Diodenschalter 12a, 12b und der dazugehörigen Dioden 17a, 17b ersetzt worden. Beide Diodenschalter 12a, 12b zusammen haben eine höhere Isolation als der Diodenschalter 12 alleine, da sich die Isolation der einzelnen Diodenschalter 12a und 12b aufsummiert. Der Entladestrom des Kondensators C steuert die beiden Dioden 17a, 17b des Diodenschalters 12 durch.

Unterhalb der beiden Dioden 17a, 17b sind sogenannte Stubs 22a, 22b angeordnet, die einen Kurzschluss für die Frequenz des hochfrequenten Trägersignals 10 darstellen. Stubs sind wellenlängenselektiv reflektierende Bauelemente. Durch die Stubs 22a, 22b werden die Dioden 17a, 17b für die Hochfrequenz (HF) auf ein festes Potential gelegt. Zudem ist in einem Zweig der Schaltung, über den der Kondensator C entladen wird, eine Reihenschaltung eines als Lambda/4-Leitung ausgebildeten invertierenden Bauelements 27 und eines Stubs 28 angeordnet. Die Lambda/4-Leitung 27 ist zwischen dem Stub 28 und den Diodenschaltern 12a, 12b angeordnet. Der Stub 28 ist für einen Frequenzbereich reflektierend, der die Frequenz des Trägersignals 10 umfasst, und für alle anderen Frequenzen leitend. Die Lambda/4-Leitung 27 und der Stub 28 bewirken zusammen einen Kurzschluss für einen bestimmten HF-Frequenzbereich.

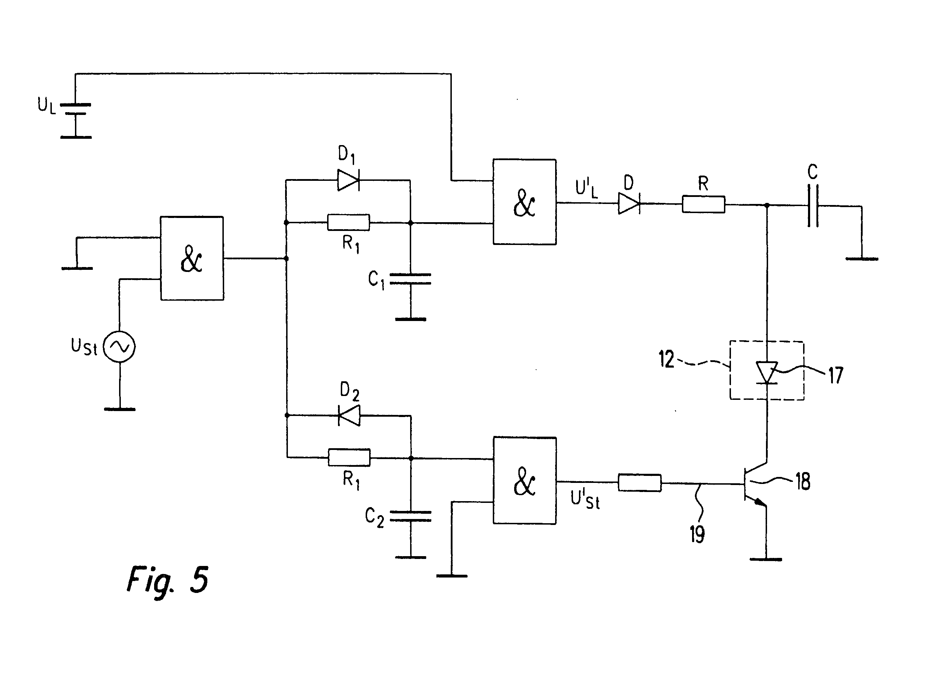

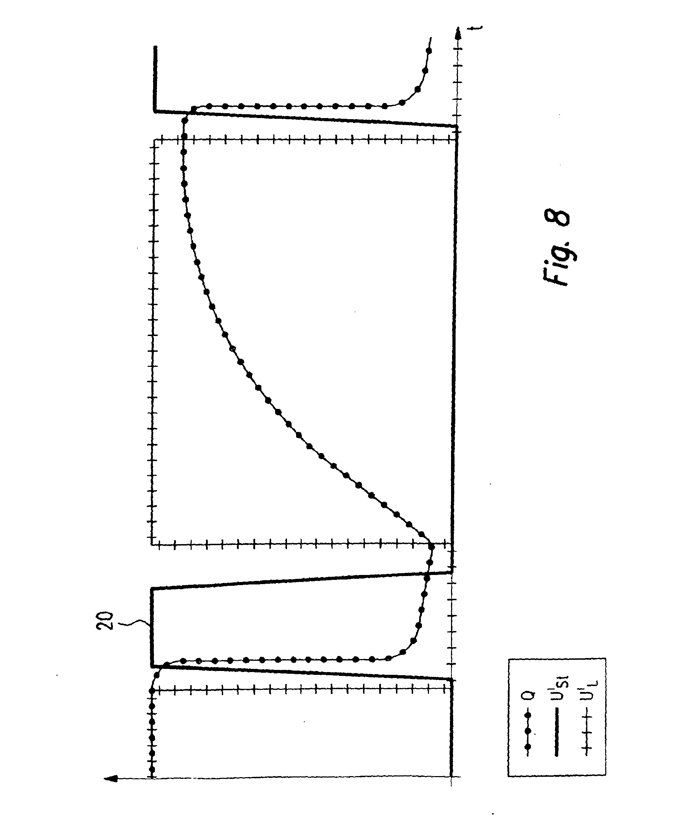

In Figur 5 ist eine erfindungsgemäße Schaltung gemäß einem vierten bevorzugten Ausführungsbeispiel dargestellt. Im Gegensatz zu der Schaltung aus Figur 1 weist die in Figur 5 dargestellte Schaltung Mittel auf, die den Ladevorgang des Kondensators C zumindest solange unterbrechen, wie an dem Transistor 18 oder alternativ bei mehreren in Serie geschalteten Transistoren 18a, 18b an mindestens einem Transistor 18a ein Ansteuerimpuls 20 anliegt. Die Mittel umfassen einseitig verzögernde Glieder R₁, D₁, C₁ und R₂, D₂, C₁, die dazu dienen, ansteigende Flanken des Ansteuersignals U_{St} und ansteigende Flanken der Ladespannung U_{L} zu verzögern (vgl. Figur 8).

Ohne diese einseitig verzögernden Glieder wäre das Ansteuersignal U_{St} genau invertiert zu der Ladespannung U_{L}. Mit den verzögernden Gliedern R₁, D₁, C₁ und R₂, D₂, C₂ kann sichergestellt werden, dass nach dem Entladen des Kondensators C kein Reststrom mehr über den Ladewiderstand R und die Diode 17 fliest. Durch die während des Ladevorgangs des Kondensators C in Durchlassrichtung geschaltete Diode D wird verhindert, dass sich der Kondensator C über den Widerstand R entlädt, wenn die Ladespannung U_{L} auf LOW wechselt, d.h. 0V beträgt. Mit '&' sind in Figur 5 EXOR-Gatter bezeichnet. Der zeitabhängige Signalverlauf der Ladung Q(t) des Kondensators C, des verzögerten Ansteuersignals U'_{St} und der verzögerten Ladespannung U'_{L} der Schaltung aus Figur 5 ist in Figur 8 dargestellt.

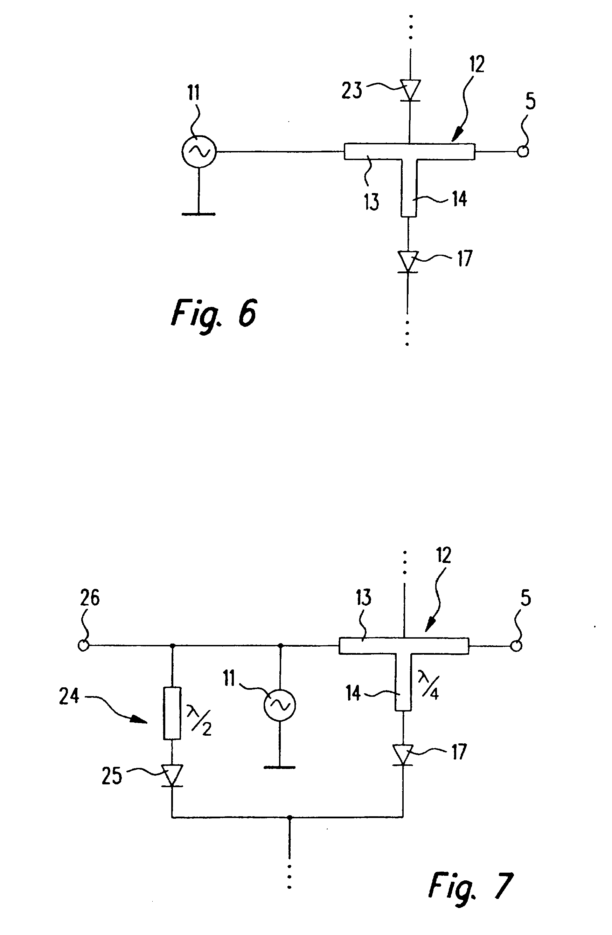

In Figur 6 ist ein Ausschnitt einer erfindungsgemäßen Schaltung gemäß einer fünften bevorzugten Ausführungsform dargestellt. Im Unterschied zu der Schaltung aus Figur 1 ist dabei in Serie mit der Stichleitung 14 bzw. bei mehreren parallel zueinander angeordneten Diodenschaltern 12a, 12b in Serie mit den Stichleitungen 14a, 14b ein als Diode ausgebildetes Halbleiterbauelement 23 angeordnet. Die Diode 23 ist während des Entladevorgangs des mindestens einen Kondensators C in Durchlassrichtung geschaltet. Durch die in Serie geschaltete Diode 23 kann die Isolation des Diodenschalters 12 weiter erhöht werden.

In Figur 7 ist ein Ausschnitt einer erfindungsgemäßen Schaltung gemäß einer sechsten bevorzugten Ausführungsform dargestellt. Im Unterschied zu der Schaltung aus Figur 1 ist dabei parallel zu dem Zweig der Schaltung mit dem Diodenschalter 12 bzw. bei mehreren parallel zueinander angeordneten Diodenschaltern 12a, 12b parallel zu den Zweigen mit den Diodenschaltern 12a, 12b ein invertierender Zweig 24 angeordnet. Der invertierende Zweig 24 weist eine gegenüber dem Zweig bzw. den Zweigen mit dem Diodenschalter 12 bzw. den Diodenschaltern 12a, 12b um Lambda/4 größere Länge auf. Im vorliegenden Ausführungsbeispiel mit einer als Lambda/4-Leitung ausgebildeten Stichleitung 14 umfasst der invertierende Zweig 24 eine Lambda/2-Leitung. In dem invertierenden Zweig 24 ist außerdem eine Diode 25 angeordnet.

An einem Ausgang 26 des invertierenden Zweiges 24 kann ein Signal abgegriffen werden, das zu dem an dem Ausgang 5 des Diodenschalters 12 anliegenden pulsmodulierten Signal 16 invertiert ist. An dem Ausgang 26 kann somit Leistung abgegriffen werden, wenn sie an dem Ausgang 5 nicht abgegriffen wird, d.h. wenn der Diodenschalter 12 sperrt. Dadurch wird verhindert, dass nicht abgegriffene Leistung in den Oszillator 11 reflektiert wird und zu einer Beeinträchtigung der Frequenz des von dem Oszillator 11 erzeugten hochfrequenten Trägersignals 10 führt. Beim Einsatz der erfindungsgemäßen Schaltung in einem Abstandsradar-System hätten Frequenzschwankungen negative Auswirkungen auf die Genauigkeit und Zuverlässigkeit des Systems. Das kann mit der Schaltung aus Figur 7 verhindert werden.

## Patentansprüche

1. Elektrische Schaltung zur Pulsmodulation eines Trägersignals (10), umfassend einen Pulsgenerator zur Erzeugung eines Stromimpulses und mindestens einen von dem Stromimpuls ansteuerbaren Diodenschalter (12; 12a, 12b) mit einer Diode (17), wobei der Diodenschalter (12; 12a, 12b) eine Signalleitung (13; 13a, 13b) und eine von dieser abzweigende Lambda/4-Stichleitung (14; 14a, 14b) aufweist, wobei das Trägersignal (10) an einem Eingang der Signalleitung (13; 13a, 13b) und das pulsmodulierte Trägersignal (16) an einem Ausgang (15) der Signalleitung (13; 13a, 13b) anliegt, und die Signalleitung (13; 13a, 13b) während des Stromimpulses durchgeschaltet ist,
**dadurch gekennzeichnet, dass** die Schaltung mindestens ein aufladbares kapazitives Element (C) aufweist und der Stromimpuls durch Entladen des kapazitiven Elements (C) über die Stichleitung (14; 14a, 14b) erzeugt wird.

2. Schaltung nach Anspruch 1, **dadurch gekennzeichnet, dass** die Schaltung mehrere Diodenschalter (12a, 12b) mit parallel zueinander geschalteten Stichleitungen (14a, 14b) aufweist.

3. Schaltung nach Anspruch 1 oder 2, **dadurch gekennzeichnet, dass** die Schaltung mindestens einen an der Stichleitung (13; 13a, 13b) des mindestens einen Diodenschalters (12; 12a, 12b) angeschlossenen Halbleiterschalter (18; 18a, 18b) aufweist, wobei das aufgeladene kapazitive Element (C) nach Ansteuerung des bzw. mindestens eines Halbleiterschalters (18; 18a) durch einen Ansteuerimpuls (20) über den oder jeden Halbleiterschalter (18; 18a, 18b) und den oder jeden Diodenschalter (12; 12a, 12b) entladbar ist.

4. Schaltung nach Anspruch 3, **dadurch gekennzeichnet, dass** der oder jeder Halbleiterschalter (18) als ein BipolarTransistor ausgebildet ist.

5. Schaltung nach Anspruch 3, **dadurch gekennzeichnet, dass** der oder jeder Halbleiterschalter (18; 18a, 18b) als ein Feldeffekt-Transistor (FET) ausgebildet ist.

6. Schaltung nach Anspruch 3 oder 4, **dadurch gekennzeichnet, dass** die Schaltung zwei Halbleiterschalter (18a, 18b) aufweist, wobei an einem Steuerkontakt (19a) des einen Halbleiterschalters (18a) der Ansteuerimpuls (20) anlegbar ist und an einem Steuerkontakt (19b) des anderen Halbleiterschalters (18b) eine variierbare Gleichspannung (U_t) anliegt.

7. Schaltung nach Anspruch 6, **dadurch gekennzeichnet, dass** die zwei Halbleiterschalter (18a, 18b) als ein Feldeffekt-Transistor (FET) mit zwei Gates ausgebildet sind.

8. Schaltung nach einem der Ansprüche 1 bis 7, **dadurch gekennzeichnet, dass** in einem Zweig der Schaltung, über den das mindestens eine kapazitive Element (C) aufgeladen wird, ein während des Ladevorgangs in Durchlassrichtung geschaltetes Halbleiterbauelement (D) angeordnet ist.

9. Schaltung nach Anspruch 8, **dadurch gekennzeichnet, dass** das Halbleiterbauelement (D) als eine Diode ausgebildet ist:

10. Schaltung nach einem der Ansprüche 3 bis 9, **dadurch gekennzeichnet, dass** die Schaltung Mittel aufweist, die den Ladevorgang des mindestens einen kapazitiven Elements (C) zumindest so lange unterbrechen, wie an dem bzw. an mindestens einem Halbleiterschalter (18; 18a) der Ansteuerimpuls (20) anliegt.

11. Schaltung nach Anspruch 10, **dadurch gekennzeichnet, dass** die Mittel einseitig verzögernde Glieder (D1, R1, C1; D2, R2, C2) zur Verzögerung der ansteigenden Flanken des Ansteuersignals (U_st) und der ansteigenden Flanken des Ladesignals (U_L) aufweisen.

12. Schaltung nach einem der Ansprüche 1 bis 11, **dadurch gekennzeichnet, dass** in Serie mit der mindestens einen Stichleitung (14; 14a, 14b) des mindestens einen Diodenschalters (12; 12a, 12b) mindestens ein während des Entladevorgangs des mindestens einen kapazitiven Elements (C) in Durchlassrichtung geschaltetes Halbleiterbauelement (23) angeordnet ist.

13. Schaltung nach einem der Ansprüche 1 bis 12, **dadurch gekennzeichnet, dass** die Schaltung einen parallel zu mindestens einem die Stichleitung (14; 14a, 14b) und die Diode (17) umfassenden Zweig geschalteten invertierenden Zweig (24) aufweist.

14. Schaltung nach Anspruch 13, **dadurch gekennzeichnet, dass** der invertierende Zweig (24) eine gegenüber dem mindestens einen Zweig mit der Stichleitung (14; 14a, 14b) und der Diode (17) um Lambda/4 größere Länge aufweist.

15. Schaltung nach einem der Ansprüche 1 bis 14, **dadurch gekennzeichnet, dass** in einem Zweig der Schaltung, über den das mindestens eine kapazitive Element (C) entladen wird, eine Reihenschaltung eines invertierenden Bauelements (27) und eines wellenlängenselektiv reflektierenden Bauelements (28) angeordnet ist, wobei das invertierende Bauelement (27) zwischen dem wellenlängenselektiv reflektierenden Bauelement (28) und dem oder jedem Diodenschalter (12; 12a, 12b) angeordnet ist und das wellenlängenselektiv reflektierende Bauelement (28) für einen Frequenzbereich, der die Frequenz des Trägersignals (10) umfasst, reflektierend und für alle anderen Frequenzen leitend ist.

16. Schaltung nach Anspruch 15, **dadurch gekennzeichnet, dass** das invertierende Bauelement (27) als eine Lambda/4-Leitung ausgebildet ist.

17. Verfahren zur Pulsmodulation eines Trägersignals (10) umfassend die Schritte:
- Erzeugen eines Stromimpulses;
- Ansteuern mindestens eines Diodenschalters (12; 12a, 12b) mit dem Stromimpuls, wobei der mindestens eine Diodenschalter (12; 12a, 12b) eine Diode (17), eine Signalleitung (13; 13a, 13b) und eine von dieser abzweigende Lambda/4-Stichleitung (14; 14a, 14b) aufweist;
- Anlegen des Trägersignals (10) an einem Eingang der Signalleitung (13; 13a, 13b);
- Abgreifen des pulsmodulierten Trägersignals (16) an einem Ausgang (15) der Signalleitung (13; 13a, 13b); und
- Durchschalten der Signalleitung (13; 13a, 13b) während des Stromimpulses ,
**dadurch gekennzeichnet, dass** der Stromimpuls durch Entladen eines aufladbaren kapazitiven Elements (C) über die Stichleitung (14; 14a, 14b) erzeugt wird.

## Claims

1. Electrical circuit for pulse modulation of a carrier signal (10), comprising a pulse generator for generating a current pulse and at least one diode switch (12; 12a, 12b) drivable by the current pulse, said diode switch having a diode (17), wherein the diode switch (12; 12a; 12b) has a signal line (13; 13a, 13b) and a λ/4 stub line (14; 14a, 14b) branching off said signal line, wherein the carrier signal (10) is applied to an input of the signal line (13; 13a, 13b) and the pulse-modulated carrier signal (16) is produced at an output (15) of the signal line (13; 13a, 13b), and the signal line (13, 13a, 13b) is connected through during the current pulse, **characterised in that** the circuit has at least one chargeable capacitive element (C) and the current pulse is generated via the stub line (14; 14a, 14b) by discharging the capacitive element (C).

2. Circuit according to claim 1, **characterised in that** the circuit comprises a plurality of diode switches (12a, 12b) with stub leads (14a, 14b) which are connected in parallel with each other.

3. Circuit according to claim 1 or 2, **characterised in that** the circuit comprises at least one semiconductor switch (18; 18a, 18b) connected to the stub line (13; 13a, 13b) of the at least one diode switch (12; 12a, 12b), wherein the charged capacitive element (C) can be discharged by a control pulse (20) via the or each of the semiconductor switches (18; 18a, 18b) and the or each diode switch (12; 12a, 12b).

4. Circuit according to claim 3, **characterised in that** the or each semiconductor switch (18) is designed as a bipolar transistor.

5. Circuit according to claim 3, **characterised in that** the or each semiconductor switch (18; 18a, 18b) is designed as a field effect transistor (FET).

6. Circuit according to claim 3 or 4, **characterised in that** the circuit comprises two semiconductor switches (18a, 18b), wherein said control pulse (20) can be applied to a control contact (19a) of one semiconductor switch (18a) and a variable direct voltage (U_t) is applied to a control contact (19b) of the other semiconductor switch (18b).

7. Circuit according to claim 6, **characterised in that** the two semiconductor switches (18a, 18b) are constructed as a field effect transistor (FET) having two gates.

8. Circuit according to one of the claims 1 to 7, **characterised in that** a semiconductor component (D) is arranged in one branch of the circuit via which the at least one capacitive element (C) is charged, said semiconductor component being connected in the conducting direction during the charging process.

9. Circuit according to claim 8, **characterised in that** the semiconductor element (D) is designed as a diode.

10. Circuit according to one of the claims 3 to 9, **characterised in that** the circuit has means for interrupting the charging process of said at least one capacitive element (c) for at least as long as said control pulse (20) is applied to said at least one semiconductor switch (18; 18a).

11. Circuit according to claim 10, **characterised in that** said means comprise unilateral delaying members (D1, R1, C1; D2, R2, C2) for delaying the rising flanks of said control signal (U_st) and the rising flanks of the charging signal (U_L).

12. Circuit according to one of the claims 1 to 11, **characterised in that** arranged in series with the at least one stub line (14; 14a, 14b) of the at least one diode switch (12; 12a, 12b) is at least one semiconductor component (23) which is connected in the conducting direction during the discharging process of said at least one capacitive element (C).

13. Circuit according to one of the claims 1 to 12, **characterised in that** the circuit has an inverting branch (24) which is connected in parallel with at least one branch comprising the stub line (14; 14a, 14b) and the diode (17).

14. Circuit according to claim 13, **characterised in that** said inverting branch (24) is longer than said at least one branch having said stub line (14; 14a, 14b) and the diode (17) by λ/4.

15. Circuit according to one of the claims 1 to 14, **characterised in that** an inverting component (27) and a wavelength-selective reflecting component (28) disposed in series are arranged in a branch of the circuit via which the at least one capacitive element (C) is discharged, wherein said inverting component (27) is disposed between said wavelength-selective reflecting component (28) and the or each diode switch (12; 12a, 12b), said wavelength-selective reflecting component (28) being reflective for a frequency range including the frequency of the carrier signal (10), and being conductive for all other frequencies.

16. Circuit according to claim 15, **characterised in that** the inverting component (27) is designed as a λ/4 line.

17. A method for pulse modulation of a carrier signal (10), comprising the steps of:
- generating a current pulse;
- controlling at least one diode switch (12; 12a, 12b) with the current pulse, wherein the at least one diode switch (12; 12a, 12b) has a diode (17), a signal line (13; 13a, 13b) and a λ/4 stub line (14; 14a, 14b) branching off said signal line;
- applying the carrier signal (10) to an input of the signal line (13; 13a, 13b);
- drawing off the pulse-modulated carrier signal (16) at an output (15) of the signal line (13; 13a, 13b); and
- connecting through the signal line (13; 13a, 13b) during the current pulse, **characterised in that** the current pulse is generated by discharging a chargeable capacitive element (C) via the stub line (14; 14a, 14b).

## Revendications

1. Circuit électrique pour la modulation d'impulsions d'un signal porteur (10) comprenant un générateur d'impulsions pour la génération d'une impulsion de courant et au moins un commutateur à diodes (12; 12a; 12b) pouvant être activé par l'impulsion de courant avec une diode (17), le commutateur à diodes (12; 12a; 12b) présentant une ligne de signalisation (13; 13a; 13b) et une ligne de branchement quart d'onde (14, 14a, 14b) s'écartant de cette ligne, le signal porteur (10) s'appliquant sur une entrée de la ligne de signalisation (13; 13a; 13b) et le signal porteur (16) modulé au niveau des impulsions s'appliquant sur une sortie (15) de la ligne de signalisation (13; 13a; 13b), et la ligne de signalisation (13; 13a; 13b) étant commutée pendant l'impulsion de courant, **caractérisé en ce que** le circuit présente au moins un élément (C) capacitif rechargeable et l'impulsion de courant est générée par le déchargement de l'élément (C) capacitif par la ligne de branchement (14; 14a; 14b).

2. Circuit selon la revendication 1, **caractérisé en ce que** le circuit présente plusieurs commutateurs à diodes (12a; 12b) avec des lignes de branchement (14a; 14b) connectées parallèlement entre elles.

3. Circuit selon la revendication 1 ou 2, **caractérisé en ce que** le circuit présente au moins un commutateur à semi-conducteurs (18; 18a; 18b) raccordé à la ligne de branchement (13; 13a; 13b) du au moins un commutateur à diodes (12; 12a; 12b), l'élément (C) capacitif rechargé pouvant être déchargé après l'activation du au moins un commutateur à semi-conducteurs (18; 18a) par une impulsion d'activation (20) au moyen du ou de chaque commutateur à semi-conducteurs (18; 18a; 18b) et du ou de chaque commutateur à diodes (12; 12a; 12b).

4. Circuit selon la revendication 3, **caractérisé en ce que** le ou chaque commutateur à semi-conducteurs (18) est conçu comme un transistor bipolaire.

5. Circuit selon la revendication 3, **caractérisé en ce que** le ou chaque commutateur à semi-conducteurs (18; 18a; 18b) est conçu comme un transistor à effet de champ (FET).

6. Circuit selon la revendication 3 ou 4, **caractérisé en ce que** le circuit présente deux commutateurs à semi-conducteurs (18a; 18b), l'impulsion d'activation (20) pouvant être appliquée sur un contact de commande (19a) d'un commutateur à semi-conducteurs (18a) et une tension continue (U_t) variable étant appliquée sur un contact de commande (19b) de l'autre commutateur à semi-conducteurs (18b).

7. Circuit selon la revendication 6, **caractérisé en ce que** les deux commutateurs à semi-conducteurs (18; 18a; 18b) sont conçus comme un transistor à effet de champ (FET) avec deux grilles.

8. Circuit selon l'une quelconque des revendications 1 à 7,
**caractérisé en ce que** dans une branche du circuit, par laquelle, le au moins un élément (C) capacitif est rechargé, est disposé un composant à semi-conducteurs (D) commuté pendant l'opération de chargement dans le sens passant.

9. Circuit selon la revendication 8, **caractérisé en ce que** le composant à semi-conducteurs (D) est conçu comme une diode.

10. Circuit selon l'une quelconque des revendications 3 à 9, **caractérisé en ce que** le circuit présente des moyens qui interrompent l'opération de chargement du au moins un élément (C) capacitif au moins aussi longtemps que l'impulsion d'activation (20) s'applique sur le commutateur à semi-conducteurs ou sur au moins un commutateur à semi-conducteurs (18; 18a).

11. Circuit selon la revendication 10, **caractérisé en ce que** les moyens présentent des éléments (D1, R1, C1; D2, R2, C2) temporisateurs d'un côté pour la temporisation des flancs croissants du signal d'activation (U_st) et des flancs croissants du signal de chargement (U_L).

12. Circuit selon l'une quelconque des revendications 1 à 11, **caractérisé en ce qu'**au moins un composant à semi-conducteurs (23) commuté dans le sens passant pendant l'opération de décharge du au moins un élément (C) capacitif est disposé en série avec la au moins une ligne de branchement (14; 14a, 14b) du au moins un commutateur à diodes (12; 12a, 12b).

13. Circuit selon l'une quelconque des revendications 1 à 12, **caractérisé en ce que** les circuits présentent une branche (24) inverseuse commutée parallèlement à au moins une branche comprenant la ligne de branchement (14; 14a, 14b) et la diode (17).

14. Circuit selon la revendication 13, **caractérisé en ce que** la branche (24) inverseuse présente une longueur supérieure d'un quart d'onde par rapport à la au moins une branche avec la ligne de branchement (14; 14a, 14b) et la diode (17).

15. Circuit selon l'une quelconque des revendications 1 à 14, **caractérisé en ce que** dans une branche du circuit, par laquelle le au moins un élément (27) capacitif est déchargé, est disposé un circuit de série d'un composant (27) inverseur et d'un composant (28) réfléchissant avec sélection de longueur d'onde, le composant (27) inverseur étant disposé entre le composant (28) réfléchissant avec sélection de longueur d'onde et le ou chaque commutateur à diodes (12; 12a, 12b) et le composant (28) réfléchissant avec sélection de longueur d'onde étant réfléchissant pour une plage de fréquences qui comprend la fréquence du signal porteur (10), réfléchissant et conducteur pour toutes les autres fréquences.

16. Circuit selon la revendication 15, **caractérisé en ce que** le composant (27) inverseur est conçu comme une ligne quart d'onde.

17. Procédé pour la modulation d'impulsions d'un signal porteur (10) comprenant les étapes suivantes:
- génération d'une impulsion de courant;
- activation d'au moins un commutateur à diodes (12; 12a, 12b) avec l'impulsion de courant, le au moins un commutateur à diodes (12; 12a, 12b) présentant une diode (17), une ligne de signalisation (13; 13a, 13b) et une ligne de branchement quart d'onde (14; 14a, 14b) s'écartant de celle-ci;
- application du signal porteur (10) sur une entrée de la ligne de signalisation (13; 13a, 13b);
- prélèvement du signal porteur (16) modulé en impulsion sur une sortie (15) de la ligne de signalisation (13; 13a, 13b); et
- une commutation de la ligne de signalisation (13; 13a, 13b) pendant l'impulsion de courant,
**caractérisé en ce que** l'impulsion de courant est généré par la décharge d'un élément (C) capacitif rechargeable au moyen de la ligne de branchement (14; 14a, 14b).
